Europäisches Patentamt

European Patent Office

Office européen des brevets

(11) Publication number: **0 311 274**
**A2**

(12) # EUROPEAN PATENT APPLICATION

(21) Application number: **88308745.4**

(22) Date of filing: **21.09.88**

(51) Int. Cl.⁴: **C03C 17/06 , C03C 23/00 , C03C 3/091 , H01L 23/14 , H05K 3/10**

(30) Priority: **07.10.87 US 105262**
        **07.10.87 US 105263**

(43) Date of publication of application:
    **12.04.89 Bulletin 89/15**

(84) Designated Contracting States:
    **DE FR GB IT NL**

(71) Applicant: **Corning Glass Works**
**Sullivan Park FR-212**
**Corning New York 14831(US)**

(72) Inventor: **Boylan, Elizabeth Ann**
**170 East Second Street**
**Corning New York(US)**
Inventor: **Hultman, Sheryl Lynn**
**184 Pearl Street**
**Corning New York(US)**
Inventor: **Fong, Gerald David**
**R.D. No. 2, Backer Road**
**Beaver Dams New York(US)**

(74) Representative: **Smith, Sydney et al**
**Elkington and Fife Beacon House 113**
**Kingsway**
**London WC2B 6PP(GB)**

(54) **Thermal writing on glass or glass-ceramic substrates and copper-exuding glasses.**

(57) There is disclosed a method of producing a transition metal pattern on a glass or glass-ceramic substrate by selective exudation of a transition metal from a glass substrate containing the metal as an oxide. The selective exudation is effected by applying an intense, well-focused source of energy to a glass in a pattern corresponding to the desired metal pattern. This develops localized heating, and thereby causes corresponding localized metal exudation from the glass. The metal pattern may be rendered electroconductive, and may constitute a pattern of interconnecting lines for microcircuitry.

There is also disclosed a family of low dielectric, copper-exuding, boroaluminosilicate glasses particularly adapted to use in forming substrates for electronic devices such as integrated circuits. The glasses are capable of exuding copper oxide, have a coefficient of thermal expansion of 30 - 35 x $10^{-7}$ at 300°C, a dielectric constant not over 5.0 at 100 KHz, a loss tangent not over 0.003 at 100 KHz and consist essentially, in percent by weight, of 56 - 64% $SiO_2$, 18 - 25% $B_2O_3$, 3-11% $Al_2O_3$, 0-2% CaO, 0 - 2% $Li_2O$, 0 - 1% $K_2O$, and $Li_2O$ + $K_2O$ + CaO being 1.5 - 3% and 1 - 20% CuO.

# THERMAL WRITING ON GLASS OR GLASS-CERAMIC SUBSTRATES AND COPPER-EXUDING GLASSES

This invention is concerned with glass or glass-ceramic substrates, having a transition metal pattern formed on their surfaces, with a method of producing such a pattern by thermal exudation of a metal from the substrate, and with a copper-exuding boroaluminosilicate glass. Patterns composed of fine lines find application in the filed of microcircuits, and other uses that require precise location of fine lines, such as precision grids and scales for instrumentation.

The trend in electronic devices generally, and microcircuitry in particular, is to continually increase density while decreasing, or miniaturizing, the size of the device and, consequently, the substrate surface. This requires forming ever greater numbers of interconnecting leads on a smaller surface. The apparent need then is for extremely narrow interconnections that have uniform continuity, and that have precise spatial separation.

There is also a need for glasses with coefficients of thermal expansion that permit serving as a substrate for silicon chips in integrated circuits, and capable of exuding copper oxide upon heat treatment.

It is known that silicon has a coefficient of thermal expansion about $32 \times 10^{-7}$ at $300\,^{\circ}$ C. Accordingly, glasses compatible with silicon should have coefficients of about 30 - 35. In addition, the glasses must have special characteristcs to be advantageously used in production of high frequency circuits. There characteristics include a dielectric constant not over 5.0 and loss tangents not over 0.003 as measured in frequency domains of interest. Finally, it would be desirable to provide electroconductive metal patterns on selected portions of the glass surface to serve as contacts, interconnections and the like. Preferably fine metal lines are desirable, which are less than 50 microns in width.

United States Patent No. 3,420,645 (Hair) discloses a method of making a hollow glass article having a metallic copper coating. Solid particles of $CuO$ - $Al_2O_3$ - $SiO_2$ glass are heated in a hydrogen-containing atmosphere to expand the particles and cause metallic copper to form on their surfaces.

United States Patent No. 3,464,806 (Seki et al.) and British Patent No. 944,571 (McMillan et al.) describe producing a copper or silver metallized glass-ceramic. A nucleating agent, and copper or silver oxide, are included in a cerammable glass, and the glass heated on a controlled cycle in a reducing atmosphere.

United States Patent No. 3,490,887 (Herczog et al.) discloses outward migration of copper ions in a ferro-electric glass-ceramic by controlled heat treatment. The copper ions oxidize at the surface to form an oxide layer that can be reduced to metallic copper by firing in hydrogen.

Kamiya et al., Journal of Non-Crystalline Solids, 80 (1986) 405-411, describe studies on the behavior of copper ions in $CuO$ - $Al_2O_3$ - $SiO_2$ glasses heated in air.

United States Patent No. 3,900,593 (Herczog et al.) discloses bonding a magnetic metal oxide film to a substrate by localized heating with a focused light source.

United States Patent No. 4,065,656 (Brown et al.), and patents disclosed therein, describe use of a laser beam to spiral resistance elements.

United States Patent No. 4,681,778 (Young) discloses a method and apparatus for making electrical connections between conductors on a substrate. A dielectric-like film is deposited on the substrate in the form of spaced islands. These may be melted by localized heating, for example a laser, to render the film conductive.

United States Patents No. 3,649,392 (Schneck) and No. 3,824,100 (Griest) exemplify circuit forming methods involving chemical etching.

United States Patent No. 4,666,551 (Baeuerle) discloses etching dielectric oxide ceramics and single crystal oxides by means of laser radiation in an atmosphere having a reducing effect on the oxide materials.

The invention provides a method of producing a desired metallic pattern of a selected transition metal on the surface of a glass or glass-ceramic substrate which comprises the steps of:

(a) providing a glass substrate having a composition containing an oxide of said selected transition metal and which is capable of exuding said selected transition metal onto the surface of said glass when subjected to thermal influence; and then

(b) applying an intense, well-focused source of energy onto the surface of said glass substrate in the form of the pattern desired for said selected transition metal in order to develop localized heating in the surface of said substrate and thereby cause said selected transition metal to exude onto the surface of said glass substrate in said desired metallic pattern.

In one specific embodiments, the pattern is composed on spatially-separated, fine lines service as lead interconnections on an electronic device such as a microcircuit. A preferred metal is copper. A preferred source of energy is a laser beam employed in conjunction with a glass containing an oxide that absorbs the light energy from the laser beam and converts it to thermal energy.

The invention also provides a family of low dielectric, copper-exuding, boroaluminosilicate glasses consisting essentially of, in percent by weight on the oxide basis, 56 - 64% $SiO_2$, 18 - 25% $B_2O_3$, 3 - 11% $Al_2O_3$, 0 - 2% CaO, 0 - 2% $Li_2O$, 0 - 1% $K_2O$, total $Li_2O$ + $K_2O$ + CaO is 1.5 - 3%, and 1 - 20% CuO, and having a coefficient of thermal expansion of 30 - 35 x $10^{-7}$ at 300° C, a dielectric constant not over 5.0 at 100 KHz, and a loss tangent not over 0.003 at 100 KHz.

In another form, the invention provides an electronic device comprising a silicon element and a substrate for the element formed from a low dielectric, copper-exuding, boroaluminosilicate glass consisting essentially of, in percent by weight on the oxide basis, 56 - 64% $SiO_2$, 18 -25% $B_2O_3$, 3 - 11% $Al_2O_3$, 0 - 2% CaO, 0 - 2% $Li_2O$, 0 - 1% $K_2O$, total $Li_2O$ + $K_2O$ + CaO is 1.5 - 3%, and 1 - 20% CuO, and having a coefficient of thermal expansion of 30 - 35 x $10^{-7}$ at 300° C, a dielectric constant not over 5.0 at 100 KHz, and a loss tangent not over 0.003 at 100 KHz.

## General Description of the Invention

The invention is based in part on the discovery that a transition metal can be selectively exuded onto predetermined portions of a glass surface in a very precisely controlled manner by thermally exciting the predetermined portions. Thus, very fine metal lines may be traced on the surface of a glass that is capable of thermally exuding the metal. The metal may appear directly, that is as metal, in some circumstances. It may also appear wholly, or in part, as the oxide. In that case, reduction to the metal may be employed.

Previous disclosures, related to overall thermal treatment of glasses capable of thermal exudation, have generally reported oxide films, such as a grey-black, copper oxide film. Thus, it was surprising to encounter direct exudation of metal, rather than oxide, despite a high concentration of oxygen, as in the presence of air.

It is our belief that this surprising metal formation occurs through a combination of (1) the absorption of high local energy densities, such as created by a focused laser, and (2) the intrinsically low thermal conductivity of the glass. Under these conditions, local temperatures on the glass surface may meet or exceed the temperature necessary to promote decomposition of initially formed oxides to elemental oxygen and metal. Such conditions are a function of both input laser power, P, and rastering rate, R.

It has been observed that the production and character of metal-containing lines do not appear correlated with the total energy, E, absorbed per unit length of application. However, the rate of energy input, either as P or R, is obviously important. It appears then that heat loss, e.g. into the glass, is a determining role in metal formation. Thus, the low heat loss in glass is significant.

It has further been noted that, if the thermal intensity (P) is decreased, or the travel rate of the thermal beam increased, there is a tendency to exude increasing amounts of oxide in preference to metal. If then, it becomes necessary to employ a reduced rate of energy input, one may reduce the oxide lines to metal at modest temperatures, e.g. 200° C in the case of copper.

It has further been found that development of a metal pattern, rather than an oxide pattern, may be insured by a rather simple expedient. This involves applying, prior to the thermal writing, an organic, carbonaceous film over the glass substrate, or at least over the portion to be written on. Any form of film or coating may be employed. Thus, cellophase tape, glue, corn oil, paper tape and plastic films, for example, have been successfully applied.

It is our belief that decomposition of the carbonaceous organic, during application of the focused energy, provides a reducing environment. This may either exclude oxygen or, it an oxide forms, reduce the oxide to the metal.

When a metal line, or other writing, is directly exuded from the glass as metal, or subsequently reduced with hydrogen for example, it generally is not electroconductive. This condition is thought to be caused by the rapid dendritic growth character of the metal during exposure to thermal influence.

However, when the metal is exuded under an organic, carbonaceous film or coating, it often is electroconductive. Where that electroconductivity is not of sufficient degree, it may be easily enhanced by an electroless deposition treatment, or by simple electrodeposition methods.

Suitable glasses to employ are any glasses known to be capable of thermal exudation of metal oxides, including those noted earlier. In general, alkali borosilicate and aluminosilicate glasses, containing a significant content of the desired metal oxide, are most suitable. We prefer to employ glasses with 1-20 percent metal oxide. Where a laser beam is used in writing, an absorbing oxide may be included in the glass to assist in absorbing sufficient optical energy and converting it to thermal energy.

Any of the transition metals known to exude may be employed. For conductive patterns, copper or silver are preferred. Thus the glass may be a copper aluminosilicate, or may be any alkali borosilicate or aluminosilicate containing copper oxide as an additive. The term "transition metal," as used herein, means a metal selected from among the transition elements.

The thermal beam may be any known source of thermal excitation that can be well focused and of controlled power. We have worked primarily with an argon laser beam. However, any sufficiently intense energy source, that produces local heating at the desired site, can be used to draw lines. This includes other types of lasers, electron beams, high intensity x-rays and well-focused heat guns.

In working with an argon laser, it is frequently desirable, although not a necessity, to include iron oxide ($Fe_2O_3$), preferalby 1 - 5% by weight, in the glass composition. The $Fe_2O_3$ assists in absorbing the light energy and converting it to thermal energy. While some iron will exude together with copper for example, the amount is relatively small and normally does not alter properties significantly. With other lasers, such as a $CO_2$ laser, oxides otehr than iron oxide may operate as an absorbent.

In carrying out the inventive method, a glass batch capable of exuding a transition metal is formulated. A selected transition metal may be incorporated in the batch as the oxide. Alternatively, it may be added as a conventional glass making compound that converts to the oxide, for example a carbonate or nitrate. The glass batch, including the metal additive, is then melted, and the melt formed into a substrate or suitable shape.

The substrate may also be produced from the base glass, that is a glass without the metal additive. The metal may then be added by subsequent treatment, for example, ion exchange.

The substrate is mounted in precise manner with relationship to the focused energy source. Either the energy source, or the substrate, usually the former, is then moved along a predetermined path. This path is determined by the desired metal pattern on the substrate. In a production process, the movement may be computer guided.

The process may be carried out in air, with direct metal formation, by selecting a suitable glass and providing the energy source with adequate power and/or rate of travel. Where metal oxide formation is encountered, the oxide may be reduced to the metal in a hydrogen-containing atmosphere, for example, forming gas.

However, for most purposes, the preferred mode is to apply an organic, carbonaceous film or coating to the substrate before applying the thermal influence. This insures metal formation during the thermal processing. Any residue may be readily removed.

Because of the wide range of compositions capable of exuding transition metals, the present method has significant advantages. Through composition variation, we may be capable of matching skpecific requirements of light absorption, dielectric constant, loss factor, thermal expansion, resistivity, durability and strength.

Radical processing advantages may also be accessible. For example, with at least one family of copper alkali borosilicates, conducting copper metal exudes in vacuo at modest temperatures below 800° C. Oxygen and hydrogen reactants are found necessary for exudation in aluminosilicate systems. Reactant-free exudation may be of critical importance when rigorously clean, in vacuo preparation of electronic devices is necessary.

Finally, thicker metal lines may be built up on the original exuded lines through conventional electrodeposition. Where an original exuded line is not electroconductive, that property may be imparted by electroless deposition. Where the line is electroconductive, as when developed under an organic film, the conductivity may be enhanced by either the electroless or conventional deposition step if necessary. Depositions by this method generally proceed preferentially at metal sites, such as are provided by the thermally drawn patterns of this invention.

Where a glass-ceramic substrate is desired, a thermally crystallizable base glass is selected for substrate formation. After the desired metal pattern has been formed by selective exudation, the substrate may then be completely exposed to a thermal treatment. This causes development of one or more crystal phases throughout the glass substrate.

In this general context, further low dielectric glasses where found that are capable of exuding copper on a surface when heat treated. The dielectric requirements are a dielectric constant not over 5.0 when measured at 100 KHz, and a loss tangent not over 0.003 when measured at 100 KHz.

It is recognized that measurement of dielectric properties may be specified at much higher frequency values for some applications. However, it has proven convenient to make measurements at 100 KHz. Furthermore, such measurements are deemed adequate, since literature reports indicate that both dielectric constant and loss tangent decrease to minimum values as the frequency of measurement is increased.

The search was further limited by the need for a coefficient of thermal expansion between about 30 and 35x $10^{-7}$ at 300°C. This was necessary to permit forming a seal with silicon in an electronic device, specifically an integrated circuit.

It was recognized that at least some borosilicates and aluminosilicates were known to be capable of exuding copper oxide under influence of heat. Likewise, both types of glass tend to have low coefficients of thermal expansion. However, glasses otherwise satisfactory generally failed to provide dielectric properties within limits. For example, one series of borosilicates containing small amounts of alumina had dielectric constants between 5.0 and 6.0 and loss tangents ranging from 0.004 to 0.014.

A known low dielectric borosilicate is composed of 70.0% $SiO_2$, 28.2% $B_2O_3$, 1.2% $Li_2O$ and 0.6% $K_2O$. The addition of CuO, in amounts up to 10% by weight, to this composition, had little effect on the low dielectric characteristics. However, the glasses failed to exude copper oxide when heat treated.

Further studies revealed that a constant of at least three (3) weight percent of alumina was required to render the glasses capable of exuding copper. However, in the absence of lithia ($li_2O$), it has been found necessary to employ at least five (5) weight percent alumina to permit copper exudation. Alumina tends to raise the dielectric values and harden the glass. Accordingly, the alumina content should not exceed about 11% by weight.

As just observed, the presence of lithia is desirable to facilitate copper exudation. However, increasing amounts of lithia tend to increase the dielectric constant. Thus restricting the lithia content to not over about four mole percent (about two wt.%).

CaO may replace $K_2O$ and partially replace the $Li_2O$ in a glass. It tends to increase the dielectric constant and decrease the expansion coefficient. Therefore, it present, this oxide must be restricted.

At least about one wt.% copper oxide is required for exudation and up to about 20% may be permissible. However, for some purposes, it is desirable to limit the content of copper oxide to not over ten weight percent, since larger amounts tend to increase the dielectric constant.

In the drawings:

FIGURE 1 is a graphical trace showing the copper content observed by microprobe analyses across a thermally exuded copper line drawn in accordance with the invention, and

FIGURE 2 is a graphical trace, similar to that of FIGURE 1, but showing the oxygen contents observed.

In one illustration of the invention, a copper-exuding, lithium aluminosilicate glass was employed. The glass composition, as calculated in weight percent on an oxide basis, was as follows:

| $SiO_2$ - | 52.6 |
|---|---|
| $Al_2O_3$ - | 28.0 |
| $Li_2O$ - | 1.8 |
| CuO - | 13.6 |
| $Fe_2O_3$ - | 4.0 |

A flat slab, cast from the glass melt, was annealed, and ground and polished. The polished sample was exposed to an argon laser beam (514 nm) of about 75 micron (3 mil) beam width. The beam had a power of 1 watt and was moved across the plate at a rate of 10 cm/sec.

A bright copper line, which appeared to be about 75 microns (3 mil) in width, was observed to develop on the glass surface as the glass was exposed to the laser beam. The sample was then subjected to a series of microprobe analyses across the width of the line. The amount of copper, in atomic percent, observed in each analysis was plotted against pattern width in microns.

As noted earlier, a minor amount of iron is exuded with the copper. If necessary, this could be avoided by omitting $Fe_2O_3$ from the glass and employing another source of energy.

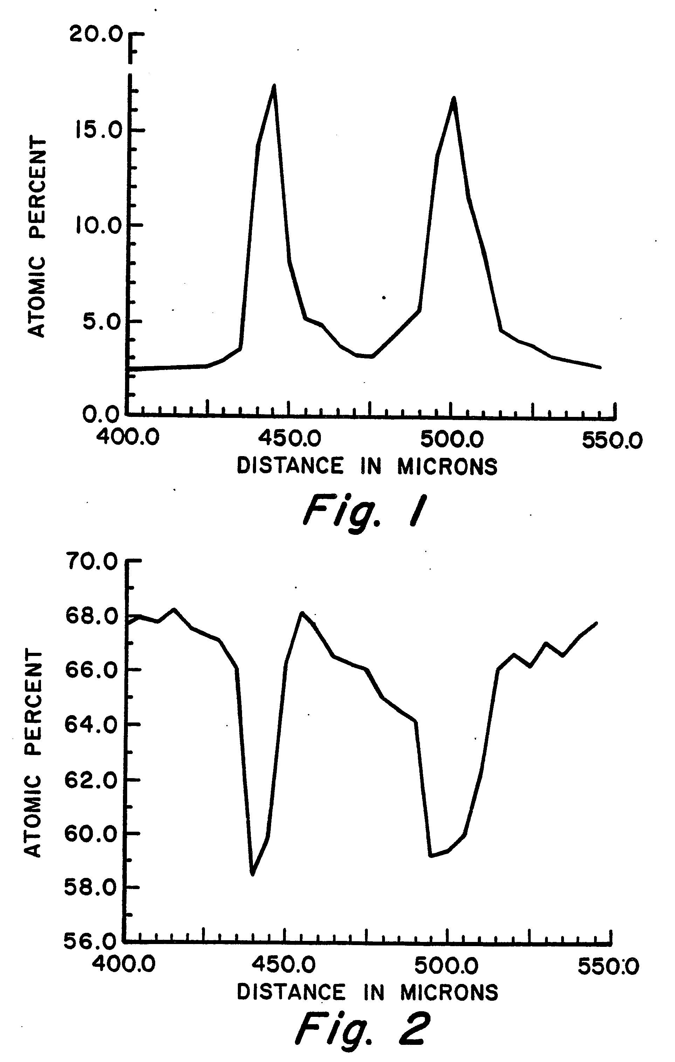

FIGURE 1 of the drawing is a graphical presentation of the microprobe data. Copper content is plotted in atomic percent along the vertical axis. The transverse distance, across which analyses were made, is plotted along the horizontal axis in microns.

It will be observed that the graphical depiction indicates two copper peaks, and, hence, essentially two lines of about 15-20 microns width (0.6 - 0.8 mil) each. This marked variation of copper concentration over the 75 micron (3 mil) beam width reflects the power distribution of, and lack of focuse in, the impinging laser beam. The results suggest that copper line widths are limited by laser resolution rather than glass characteristics.

It may be noted that the microprobe sampling resolution is about 2 microns, (0.08 mil) whereas the copper line formed is less than one micron (0.04 mil) in depth. Hence, a portion of the measurement is of a surface layer on the glass wherein both Cu and 0 are found. In the initial copper layer, virtually no oxygen is found in the microprobe analysis.

FIGURE 2 of the drawing is the same as FIGURE 1, except that atomic percent oxygen is plotted on the vertical axis. Thus, it might be considered as the reverse of the FIGURE 1 data and representation. It may also be considered as confirmation.

By way of further illustration, the same glass was subjected to a variety of laser writing conditions employing the same argon laser. The variable conditions employed, and the resulting characteristics of the lines traced, are set forth in TABLE 1 below wherein,

| P = | laser power in watts |
|---|---|
| R = | travel rate of the beam in centimeters/second (cm/s) |
| E = | absorbed energy in joules/centimeter expressed as Power/Travel Rate |
| W = | line width in microns as measured from photomicrograph at 63X magnification |
| f = | ratio of copper at surface to copper in glass microprobe |
| Cu/O = | mole ratio of maximum copper to oxygen content at the same point, as shown by microprobe analysis. |

TABLE 1

| P(W) | R(cm/s) | E(Joules/cm) | W(u) | f | Cu/O |
|---|---|---|---|---|---|
| 0.05 | 0.01 - 0.25 | 5 - 0.20 | none | 1.0 | |
| 0.10 | 0.02 - 1.00 | 5 - 0.10 | none | 1.0 | 0.04 |
| 0.20 | 0.10 - 2.00 | 2 - 0.10 | none | 1.0 | |
| 0.50 | 0.10 | 5 | 120 | 2.3 | 0.12 |
| | 0.25 | 2 | 68 | 1.6 | 0.06 |
| | 1.00 | 0.5 | 45 | 1.5 | 0.05 |
| | 5.00 | 0.1 | 23 | 1.0 | 0.04 |
| 1.00 | 0.20 | 5 | 150 | 6.2 | 0.34 |
| | 0.50 | 2 | 128 | 7.1 | 0.35 |
| | 2.00 | 0.5 | 113 | 7.2 | 0.31 |
| | 5.00 | 0.2 | 68 | 3.2 | 0.24 |
| | 10.00 | 0.1 | 53 | 2.0 | 0.10 |

The variation in travel rate and energy values in the first three lines indicate that power level was inadequate to cause copper exudation regardless of how slow the beam traveled. The remaining data illustrate the effects of varying power and rate.

In another example of the invention, electroconductive lines were produced on an optically flat, alkali boroaluminosilicate glass substrate. The calculated glass composition, in weight percent, is:

| $SiO_2$ | 60.4 |
|---|---|
| $B_2O_3$ | 19.8 |
| $Al_2O_3$ | 7.9 |
| $Li_2O$ | 1.0 |
| $K_2O$ | 0.5 |
| $Fe_2O_3$ | 3.9 |
| CuO | 6.5 |

The substrate was exposed to the argon laser beam, described above, under varying conditions.

Copper lines were formed varying in width from 5 - 50 microns (0.2 - 2 mils) and a few tenths of a micron in depth.

The copper lines, as formed, were not conductive, a condition thought to be caused by the rapid dendritic growth character of the copper during laser exposure. However, when dipped in an electroless copper plating solution for a few minutes, the lines showed resistance values of 5 - 100 ohm-cm, while retaining their fine resolution.

Metallic copper lines have also been formed on a copper-exuding glass substrate using a $CO_2$ laser having a light output wavelength of 10,600 nm. The laser was operated with P ranging from 3 to 6 watts, and R ranging from 0.3 to 1.5 cm/sec. It employed an 8 cm (3.2") focal length germanium lens and a 0.075 cm (0.03") output beam diameter. Copper metal lines of 100 - 300 microns (4 - 12 mils) in width were obtained. These lines were not electroconductive unless an organic coating in the form of cellophane tape or other common, carbonaceous film overlaid the glass. Electroconductivity was imparted, or enhanced, by dipping in an electroless plating solution as before.

The copper oxide-exuding glass substrates used in these experiments were produced from lithium and sodium aluminosilicates, alkali-free aluminosilicates, and borosilicate base glasses. These glasses did not require an added absorbing oxide, since the 10,600 nm wavelength is strongly absorbed by any glass containing substantial silica.

Similar behavior to the above has been obtained for glasses containing other transition metals. For example, an iron-containing glass, when exposed to $CO_2$ irradiation under conditions similar to the above copper glasses, formed iron lines, particularly when a carbonaceous film in the form of Scotch tape was initially present. Higher power ( 8 watts) at a 1.5 cm/s raster rate also favored iron line formation. The calculated iron-containing glass composition, in weight percent, is:

| | |
|---|---|
| $SiO_2$ | 68.3 |
| $Al_2O_3$ | 17.7 |
| $Li_2O$ | 3.9 |
| LiCl | 0.4 |
| $TiO_2$ | 4.4 |
| $Fe_2O_3$ | 5.3 |

Virtually identical conditions were used to form cobalt metal lines on a cobalt-exuding glass having this composition in weight percent:

| | |
|---|---|
| $SiO_2$ | 76.0 |
| $B_2O_3$ | 11.8 |
| $Al_2O_3$ | 2.2 |
| $Na_2O$ | 3.8 |
| $Co_3O_4$ | 6.2 |

TABLE II sets forth compositions for several exemplary new glasses which were found. These compositions are calculated on the oxide basis from the glass batch, and are given in parts by weight. Since the total approximates 100 in each case, the compositions may be taken as if in percent by weight.

The table further sets forth a number of property measurements made on glasses having the indicated compositions. The dielectric constant (K) was measured at 100 KHz; the loss tangent (LT) at 2.5 GHz for Examples 1-4, and at 100 KHz for Examples 5 and 6; the coefficients of thermal expansion (CTE x $10^{-7}$) at 300° C. The surface resistance of thermally exuded copper, as measured on each Example, was uniformly low (less than 5 ohm-cm).

TABLE II

| | 1 | 2 | 3 | 4 | 5 | 6 |
|---|---|---|---|---|---|---|
| $SiO_2$ | 63.7 | 62.8 | 60.8 | 59.7 | 62.6 | 60.6 |
| $B_2O_3$ | 22.8 | 20.6 | 19.8 | 18.1 | 20.6 | 19.9 |
| $Al_2O_3$ | 5.0 | 8.2 | 8.1 | 11.1 | 8.2 | 7.9 |
| $Li_2O$ | 1.1 | 1.1 | 1.1 | 1.1 | 0.8 | 1.1 |
| CuO | 6.8 | 6.7 | 9.7 | 9.5 | 6.7 | 6.5 |
| $K_2O$ | 0.6 | 0.6 | 0.6 | 0.5 | 0.6 | 0.6 |
| CaO | - | - | - | - | 0.5 | - |
| $Fe_2O_3$ | - | - | - | - | - | 3.5 |
| K | 4.47 | 4.63 | 4.75 | 4.87 | 4.90 | 4.48 |
| Lt | 0.0015 | 0.0020 | 0.0020 | 0.0020 | 0.0010 | 0.0020 |
| C.T.E. | 32.8 | 34.5 | 34.8 | 30.5 | 31.3 | - |

Glass batches corresponding to each of the compositions in TABLE II were mixed, melted and poured into molds, or rolled into 1/8" (3mm) patties, for measurement of properties. The batches were melted in silica crucibles for six hours at 1600°C. Standard commercial raw materials were employed.

The glass test pieces were fired in air for six hours at 550°C, then examined for exudation of copper oxide as a dull gray surface coating. If none was observed, a sample was successively fired at 50°C, the glass was rejected, since higher temperatures would tend to soften and distort the glass.

If a sample did exude copper oxide, it was then heated in a hydrogen atmosphere for 2 to 4 hours at 320°C, after first purging the furnace with nitrogen. The samples were cooled to 100°C in hydrogen, and then exposed to nitrogen for cooling to ambient and purging of the hydrogen.

Discs two inches in diameter were then ground and polished, and painted with a silver paint for dielectric measurements.

TABLE II sets forth compositions of several boroaluminosilicates and borosilicates that are related to the glasses of the invention, but do not provide the desired properties. These glass compositions are calculated in the manner described for those of TABLE II. Also, glasses were prepared, and properties measured, in the same manner as described with reference to TABLE II, except that loss tangent was measured at 100 KHz on all samples.

TABLE III

| | 7 | 8 | 9 | 10 |
|---|---|---|---|---|
| $SiO_2$ | 72.8 | 66.4 | 59.7 | 63.0 |
| $B_2O_3$ | 11.3 | 26.8 | 17.7 | 24.5 |
| $Al_2O_3$ | 6.2 | - | 11.2 | - |
| $Li_2O$ | - | 1.2 | 0.5 | 1.1 |
| $Na_2O$ | 3.6 | - | - | - |
| $K_2O$ | - | 0.6 | 0.5 | 0.6 |
| CuO | 6.1 | 5.0 | 9.5 | 6.8 |
| CaO | - | - | 1.0 | - |
| $Fe_2O_3$ | - | - | - | 3.6 |
| Cl | - | - | - | 0.4 |
| K | 5.70 | 4.41 | 5.11 | 4.51 |
| LT | 0.014 | <0.001 | 0.003 | 0.006 |
| C.T.E. | - | - | 28.1 | - |

The glass of Example 7, after heat treatment at 550°C, 650°C and 770°C failed to exude at any of the three temperatures. Likewise, the glass of Example 8 was heat treated at 450°C and 700°C and failed to exude at either temperature.

Example 9 illustrates the fact that CaO substitution for $Li_2O$ reduces the coefficient of thermal expansion markedly. While this can be beneficial, it must be used with caution. The glass of Example 10 exuded only slightly with heat treatment, and was non-conducting after hydrogen reduction.

The invention has thus far been described with reference to film formation of copper on glass samples. That is, of course, a useful application of the glasses, as well as being a convenient method of determining exudation characteristics in successive series of glass melts. However, a particular utility of our glasses is for thermal writing as disclosed in the companion application noted earlier as a related application.

As an example of that preferred aspect of the invention, metallic copper lines were produced directly on an optically flat glass substrate, that is, without hydrogen reduction. The composition of the glass substrate was that of Example 2 in TABLE II.

The substrate was rastered beneath an argon laser beam of 514 nm. wavelength operating at one watt power. Copper lines were formed with the beam traveling at different rates. These lines varied in width from 5 - 50 microns (0.2-2 mils), depending on the travel rate, and were a few tenths of a micron in depth.

The copper lines, as formed, were not electroconductive. It is thought that is caused by the rapid dendriticgrowth character of the copper during exposure to the laser beam. However, when the substrate was dipped in an electroless plating solution for a few minutes, the lines showed resistance values of 5 - 100 ohm-cm. while retaining their fine resolution.

While working with an argon laser, it is frequently desirable, although not a necessity, to include up to about 5% $Fe_2O_3$ in the glass composition. This assists in absorbing the optical energy and converting it to thermal energy.

## Claims

1. A method of producing a desired metallic pattern of a selected transition metal on the surface of a glass or glass-ceramic substrate which comprises the steps of:

(a) providing a glass substrate having a composition containing an oxide of said selected transition metal and which is capable of exuding said selected transition metal onto the surface of said glass when subjected to thermal influence; and then

(b) applying an intense, well-focused source of energy onto the surface of said glass substrate in the form of the pattern desired for said selected transition metal in order to develop localized heating in the surface of said substrate and thereby cause said selected transition metal to exude onto the surface of said glass substrate in said desired metallic pattern.

2. A method in accordance with claim 1 wherein said transition metal is selected from the group consisting of copper, cobalt, and iron.

3. A method in accordance with claim 1 wherein said glass is a borosilicate or an aluminosilicate.

4. A method in accordance with claim 1 wherein the amount of said oxide of said selected transition metal in the glass composition is 1 - 20% by weight.

5. A method in accordance with claim 1 wherein said energy source is a laser beam, and the glass additionally contains an absorbent for the optical energy of that laser beam.

6. A method in accordance with claim 5 wherein said energy source is an argon laser, and said absorbent is iron oxide.

7. A method in accordance with claim 6 wherein the content of iron oxide is 1 - 5%.

8. A method in accordance with claim 5 wherein said energy source is a $CO_2$ laser, and said absorbent is a silicate glass that absorbs the optical energy.

9. A method in accordance with claim 1 wherein said transition metal exudes in the presence of oxygen and remains essentially unoxidized.

10. A method in accordance with claim 1 wherein said glass substrate, having an exuded, transition metal pattern on its surface, is heated to convert the glass to a glass-ceramic.

11. A method in accordance with claim 1 wherein at least that portion of said glass substrate, upon which said transition metal pattern is to be produced by applying a source of energy, is covered with an organic, carbonaceous material before applying said source of energy.

12. A method in accordance with claim 11 wherein said organic carbonaceous material is selected from the group consisting of tapes, plastic films, glue and corn oil.

13. A method in accordance with claim 1 wherein said source of energy is applied through an organic, carbonaceous material.

14. A method in accordance with claim 1 wherein said exuded metal exists at least in part as an oxide, and the pattern is subjected to a reducing atmosphere to reduce the oxide to metal.

15. A method in accordance with claim 14 wherein said reducing atmosphere contains hydrogen.

16. A method is accordance with claim 1 wherein said substrate glass is a borosilicate, and said localized heating takes place in a vacuum.

17. A method in accordance with claim 1 wherein said substrate, with a metal pattern thereon, is exposed to electroless deposition or electrodeposition to impart or enhance electroconductivity in the pattern.

18. A method in accordance with claim 17 wherein said metal is copper.

19. An article of manufacture comprising a glass or glass-ceramic substrate having an exuded transition metal on its surface in a thermally written pattern.

20. A family of low dielectric, copper-exuding boroaluminosilicate glasses consisting essentially of, in percent by weight on the oxide basis, 56 - 64% $SiO_2$, 18 -25% $B_2O_3$, 3 - 11% $Al_2O_3$, 0 - 2% CaO, 0 - 2% $Li_2O$, 0 - 1% $K_2O$, the total $Li_2O$ + $K_2O$ + CaO being 1.5 - 3%, and 1 - 20% CuO, 0 - 5% $Fe_2O_3$, and having a coefficient of thermal expansion of 30 - 35 x $10^{-7}$ at 300˚ C, a dielectric constant not over 5.0 at 100 KHz, and a loss tangent not over 0.003 at 100 KHz.

21. A family of glasses in accordance with claim 20 wherein the CuO content is not over 10%.

22. An electronic device comprising a silicon element and a substrate for the element formed from a low dielectric, copper-exuding, boroaluminosilicate glass consisting essentially of, in percent by weight on the oxide basis, 56 - 64% $SiO_2$, 18 - 25% $B_2O_3$, 3-11% $Al_2O_3$, 0 - 2% CaO, 0 - 2% $Li_2O$, 0 - 1% $K_2O$, the total $Li_2O$ + $K_2O$ + CaO being 1.5 3%, and 1 - 20% CuO, 0 - 5% $Fe_2O_3$, and having a coefficient of thermal expansion of 30 - 35 x $10^{-7}$ at 300˚ C, a dielectric constant not over 5.0 at 100 KHz, and a loss tangent not over 0.003 at 100 KHz.

Fig. 1

Fig. 2